# EUROPEAN PATENT SPECIFICATION

(11) **EP 0 560 349 B1**
(45) Date of publication and mention of the grant of the patent: **10.06.1998**
(21) Application number: 93103901.0
(22) Date of filing: 10.03.1993
(51) Int. Cl.: G03F 7/028

(54) **Presensitized lithographic plate and process for preparation of lithographic plate**
Vorsensibilisierte lithographische Platte und Verfahren zur Herstellung lithographischer Platte
Plaque lithographique présensibilisée et méthode de préparation de plaque lithographique

(30) Priority: 11.03.1992 JP 87794/92
(43) Date of publication of application: 15.09.1993
(73) Proprietor: FUJI PHOTO FILM CO., LTD., Kanagawa (JP)
(72) Inventor: Takeda, Keiji, Haibara-gun, Shizuoka (JP); Koizumi, Shigeo, Haibara-gun, Shizuoka (JP); Hirano, Tsumoru, Haibara-gun, Shizuoka (JP)
(74) Representative: Patentanwälte Dr. Solf & Zapf

(56) References cited:
- EP-A- 426 192
- JP-A- 2 085 855
- JP-B-62 014 827

## Description

### FIELD OF THE INVENTION

The present invention relates to a presensitized lithographic plate using a polymerization reaction caused by silver halide. More particularly, the invention relates to a presensitized lithographic plate which is printable without use of dampening water (i.e., a waterless lithographic plate). The invention also relates to a process of preparation of a lithographic plate using the presensitized lithographic plate.

### BACKGROUND OF THE INVENTION

Various presensitized lithographic plates have been proposed as the waterless lithographic plate. An excellent embodiment of the presensitized waterless lithographic plate comprises a support, a light-sensitive layer and an ink-repellent layer in the order. The photosensor of the light-sensitive layer is a photopolymerization initiator or a diazo compound. The ink-repellent layer contains a silicone rubber or a fluororesin. A presensitized lithographic plate using the silicone rubber is disclosed in US-A- 3,511,178, 3,632,375, 3,677,178 and 3,894,873.

By the way, an image forming method using a light-sensitive material is disclosed JP-B- 45-11149 (corresponding to US-A- 3,697,275, DE-C- 1720665 and GB-B- 1131200). The material contains silver halide, a reducing agent and a polymerizable compound. The method comprises the steps of imagewise exposing to light the light-sensitive material and developing the material to harden imagewise the polymerizable compound to form a polymer image. JP-A- 58-121031 (corresponding to US-A- 4,547,450 and DE-A- 3300817) discloses a light-sensitive material compring a light-sensitive layer containing silver halide and a polymerizable layer containing a polymerizable compound. Further, an image forming method using a heat development is disclosed in JP-A- 61-69062, 61-73145, US-A- 4,629,676 and EP-A- 0174634.

The light-sensitive material containing silver halide, a reducing agent and a polymerizable compound can be used as a presensitized lithographic plate. The presensitized lithographic plate using silver halide is disclosed in JP-A- 63- 187245 and 64 -17047, US-A- 4,879,201 and 4,916,041. However, a waterless lithographic plate having an ink-repellent layer is disclosed in only JP-A- 63-187245.

JP-A- 63-187245 discloses a presensitized waterless lithographic plate using light-sensitive microcapsules containing silver halide and a polymerizable compound.

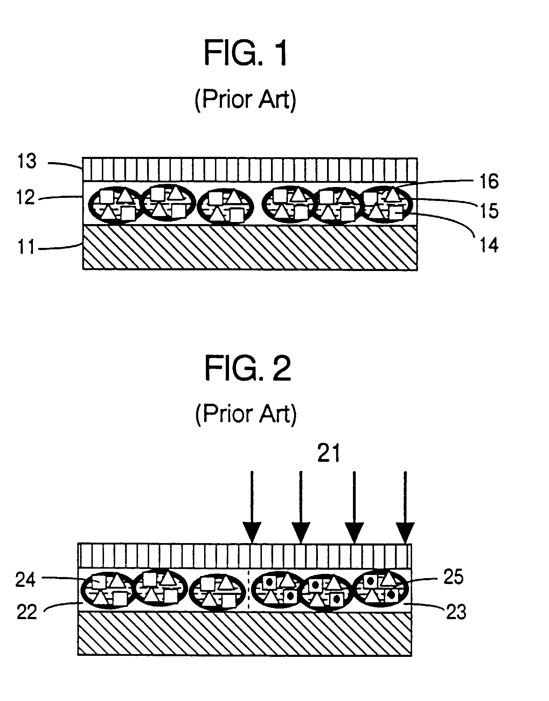

Fig. 1 is a sectional view schematically illustrating the presensitized waterless lithographic plate.

As is shown in Fig. 1, the presensitized lithographic plate disclosed in JP-A-. 63-187245 comprises a support (11), a light-sensitive layer (12) and a silicone rubber layer (13) in the order. Silver halide (14), a reducing agent (15) and a polymerizable compound (16) are contained in microcapsules which are dispersed in the light-sensitive layer (12).

A lithographic plate is prepared by imagewise exposing to light the presensitized lithographic plate, heating the plate to develop silver halide, and heating at a high temperature or pressing the plate.

Fig. 2 is a sectional view schematically illustrating the exposure step.

As is shown in Fig. 2, a latent image of silver halide (25) is formed within the area (23) exposed to light (21). On the other hand, silver halide (24) is not changed within the unexposed area (22).

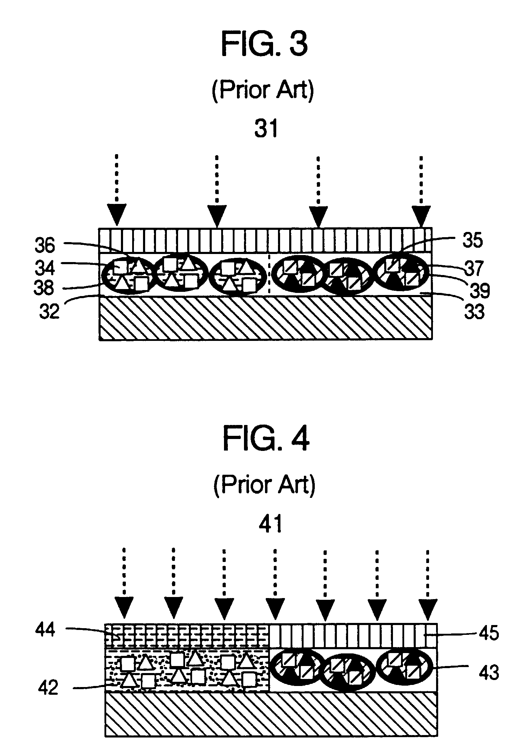

Fig. 3 is a sectional view schematically illustrating the heat development step.

As is shown in Fig. 3, the silver halide within the exposed area (33) is developed by the function of the reducing agent to form a silver image (35) when the presensitized lithographic plate is uniformly heated (31). Thus a radical (37) is formed from an oxidation product of the reducing agent. The polymerizable compound (39) is hardened by the function of the radical. On the other hand, the silver halide (34), the reducing agent (36) and the polymerizable compound (38) are substantially not changed within the unexposed area (32).

Fig. 4 is a sectional view schematically illustrating the highly heating step.

As is shown in Fig. 4, the microcapsules (42) within the unexposed area are ruptured when the lithographic plate is heated at a high temperature. The polymerizable compound released from the ruptured microcapsules in the light-sensitive layer permeates a silicone rubber layer (44). Accordingly, the silicone rubber layer within the unexposed area loses its ink-repellency. On the other hand, the microcapsules within the exposed area (43) are not ruptured because they are hardened. Accordingly, the silicone rubber layer within the exposed area (45) has the ink-repellency.

As is described above, the presensitized waterless lithographic plate disclosed in Japanese Patent Provisional Publication No. 63(1988)-187245 has an advantage that a lithographic plate can be prepared using silver halide as a photosensor without use of a developing solution.

### SUMMARY OF THE INVENTION

The conventional presensitized waterless lithographic plate uses a photopolymerization initiator or a diazo compound as a photosensor. A process for preparation of the lithographic plate employs a photopolymerization or light hardening reaction caused by the photopolymerization initiator or a photodecomposition reaction of the diazo compound. However, the sensitivities of the photopolymerization initiator or the diazo compound are low. Further, their main spectral sensitivities are included within the near ultraviolet region. Accordingly, it is difficult to sensitize spectrally the photopolymerization initiator or the diazo compound within the visible light region. Further, the lithographic plate is preferably scanned with a laser beam in a direct digital process for preparation of a lithographic plate. In such case, a very high sensitivity and a broad spectral region including the visible light region for the laser beam are required with respect to the presensitized lithographic plate

The presensitized lithographic plate disclosed in JP-A- 63-187245 comprises a light-sensitive layer containing microcapsules and a silicone rubber layer (ink-repellent layer) provided thereon, as is described in Fig. 1. The microcapsules contain silver halide and a polymerizable compound. The sensitivity and the spectral region of the presensitized lithographic plate are improved because the plate uses silver halide as a photosensor. However, the polymerizable compound is contained in microcapsules, and the microcapsules are surrounded with a hydrophilic polymer.

Accordingly, the adhesion between the ink-repellent layer and the light-sensitive layer is weak because of this structure. Therefore, the ink-repellent layer tends to be peeled from the light-sensitive layer while printing. The plate wear is poor. Further, a process for preparation of the lithographic plate requires a step of encapsulation, which is rather complicated.

The process for preparation of the lithographic plate disclosed in JP-A-63-187245 contains a step of highly heating or pressing the plate to rupture the unhardened microcapsules, as is shown in Figs 2 to 4. The polymerizable compound released from the ruptured microcapsules permeates (or is diffused to) an ink-repellent layer to form an image area (ink receiving area). Accordingly, permeation of diffusion is a key element of the image formation. Therefore, the obtained image is rather unclear, and it is difficult to obtain an image (lithographic plate) of high quality. Further, the process requires the highly heating or pressing step after the heat development. This step needs complicated process and apparatus.
EP 0 426 192 A2 discloses a light-sensitive material which contains silver halide, a reducing agent, an ethylenically unsaturated polymerizable compound or/and a cross-linkable polymer, and a base or/and a base precursor, wherein the light-sensitive material comprises a support, a polymerizable layer and a light-sensitive layer in the order, said polymerizable layer containing the ethylenically unsaturated polymerizable compound or/and the cross-linkable polymer, and said light-sensitive layer containing silver halide, and the base or/and the base precursor.

An object of the present invention is to provide a presensitized lithographic plate, which has a high sensitivity to a broad spectral region including a visible region, a near ultraviolet region and a near infrared region.

Another object of the invention is to provide a presensitized lithographic plate, which forms a lithographic plate having an image of high quality and showing excellent plate wear.

There is provided by the present invention a presensitized lithographic plate which contains silver halide, a reducing agent and an ethylenically unsaturated polymerizable compound or a cross-linkable polymer provided on a support, wherein the presensitized lithographic plate comprises the support, a polymerizable layer uniformly containing the polymerizable compound or the cross-linkable polymer, an ink-repellent layer and a light-sensitive layer containing silver halide in that order, wherein the ink-repellent layer contains a cross-linked silicone rubber or a cross-linked fluororesin.

There is also provided by the invention a process for the preparation of a lithographic plate comprising the steps of:
- imagewise exposing to light the presensitized lithographic plate defined in any one of claims; 1,2,8 or 9
- simultaneously or thereafter heating the plate at a temperature of not lower than 60°C to develop the silver halide and to harden the polymerizable compound or the cross-linked polymer; and
- removing the ink-repellent layer on the unhardened area of the polymerizable layer.

The presensitized lithographic plate of the invention has an ink-repellent layer. However, the plate does not contain microcapsules, and the polymerizable compound or the cross-linkable polymer forms a uniform polymerizable layer, while the presensitized lithographic plate disclosed in JP-A-63- 187245 contains microcapsules (which is hereinafter referred to as "encapsulated system"). In the present specification, the expression "the polymerizable compound or the cross-linkable polymer forms a uniform polymerizable layer" means that the polymerizable compound, the cross-linkable polymer or a mixture thereof is uniformly contained in the polymerizable layer.

The presensitized lithographic plate of the present invention has the following effects, compared with the encapsulated system.

The plate wear of the encapsulated system is poor, since the ink-repellent layer does not adhere to the light-sensitive layer within the hardened area (i.e., non-image area which is repellent to ink). On the other hand, the plate wear of the encapsulated system is high, since the ink-repellent layer adheres to the polymerizable layer after the polymerizable layer is hardened.

According to the encapsulated system, the obtained image is rather unclear, since the image is formed by diffusing the polymerizable compound to the ink-repellent layer to change the layer to an image area (ink receiving area). On the other hand, the obtained image of the present invention is clear, since the image is formed by removing the ink-repellent layer which does not adhere to the polymerizable layer.

The above-mentioned effects of the invention are caused by the inherent differences in the structure of the lithographic plate and the reaction mechanism between the invention and the encapsulated system. Accordingly, the effects cannot be expected from the disclosures with respect to the encapsulated system.

Further, the present invention does not require an encapsulating step in preparation of a lithographic plate. Furthermore, the invention does not require a highly heating or pressing step in preparation of a lithographic plate. These advantages are practically important.

Moreover, the presensitized lithographic plate of the invention has a high sensitivity to a broad spectral region including a visible region, compared with the conventional waterless lithographic plates using a photopolymerization initiator or a diazo compound.

### BRIEF DESCRIPTION OF THE DRAWINGS

Fig. 1 is a sectional view schematically illustrating the presensitized waterless lithographic plate disclosed in JP-A- 63-187245.

Fig. 2 is a sectional view schematically illustrating the exposure step.

Fig. 3 is a sectional view schematically illustrating the heat development step.

Fig. 4 is a sectional view schematically illustrating the highly heating step.

Fig. 5 is a sectional view schematically illustrating the most preferred embodiment of the presensitized lithographic plate of the present invention.

Fig. 6 is a sectional view schematically illustrating another preferred embodiment of the presensitized lithographic plate of the present invention.

Fig. 7 is a sectional view schematically illustrating the exposure step.

Fig. 8 is a sectional view schematically illustrating the heat development step.

Fig. 9 is a sectional view schematically illustrating the step of removing the ink-repellent layer.

### DETAILED DESCRIPTION OF THE INVENTION

The presensitized lithographic plate of the present invention is imagewise exposed to light to form a latent image of silver halide, and is heated to develop the silver halide. In the heat development, the polymerizable compound or the cross-linkable polymer contained in the polymerizable layer is hardened to adhere to the ink-repellent layer. Thus, a non-image area of the ink-repellent layer is formed. On the other hand, the image area (ink-receiving area) is formed by removing the ink-repellent layer on the unhardened area of the polymerizable layer. The ink-repellent layer may be removed, for example by washing the plate with an etching solution to dissolve a part of the unhardened polymerizable layer. Therefore, the ink-repellent layer is preferably provided just on the polymerizable layer. However, a thin (e.g., 3 µm or less) intermediate layer may be provided between the polymerizable layer and the ink-repellent layer. After preparation of the lithographic plate, the ink-repellent layer must be the uppermost layer of the plate. Accordingly, the ink-repellent layer should be provided on the polymerizable layer. In other words, the polymerizable layer should be provided between the ink-repellent layer and the support.

Silver halide may be added to the polymerizable layer or the ink-repellent layer. However, the silver halide is preferably contained in another (light-sensitive) layer, particularly in the case that it is difficult to disperse the silver halide in the polymerizable layer or the ink-repellent layer, or that silver halide degrades the ink-repellency of the ink-repellent layer.

The reducing agent is preferably added to the light-sensitive layer or a layer adjacent to the light-sensitive layer (e.g., the polymerizable layer, a primer layer, the ink-repellent layer, an intermediate layer, a protective layer, an overcoating layer).

The light-sensitive layer containing silver halide is preferably provided on the ink-repellent layer or under the polymerizable layer. The light-sensitive layer may also be provided between the polymerizable layer and the ink-repellent layer. In this case, however, the light-sensitive layer should be prepared as such a thin (e.g., 3 µm or less) layer that the light-sensitive layer does not inhibit the adhesion of the polymerizable layer to the ink-repellent layer.

The ink-repellent layer or another intermediate layer (e.g., a protective layer provided on the ink-repellent layer) may intervene between the polymerizable layer and the light-sensitive layer. The present inventors have found that a radical formed in the light-sensitive layer can be diffused through the ink-repellent layer or an intermediate layer to the polymerizable layer. Accordingly, the ink-repellent layer or the intermediate layer does not disturb the image forming reactions. It is a surprising discovery that the radical can permeate such a repellent layer.

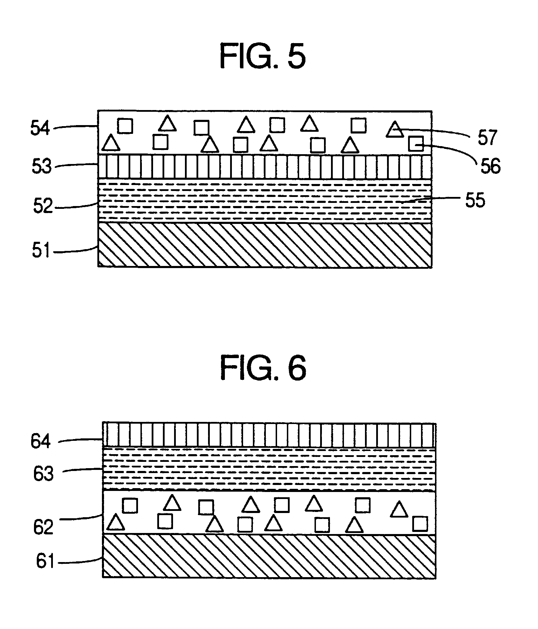

Fig. 5 is a sectional view schematically illustrating the most preferred embodiment of the presensitized lithographic plate of the present invention.

As is shown in Fig. 5, the plate comprises a support (51), a polymerizable layer (52), an ink-repellent layer (53) and the light-sensitive layer (54) in the order. The polymerizable layer (52) contains a polymerizable compound (55). The light-sensitive layer (54) contains silver halide (56) and a reducing agent (57).

Fig. 6 is a sectional view schematically illustrating another preferred embodiment of the presensitized lithographic plate of the present invention.

As is shown in Fig. 6, the plate comprises a support (61), a light-sensitive layer (62), a polymerizable layer (63) and an ink-repellent layer (64) in the order.

An overcoating layer may be provided as the uppermost layer regardless of the arrangement of the other layer. The overcoating layer has a function of preventing oxygen from permeating the polymerizable layer from the air. The oxygen inhibits the polymerization reaction. The overcoating layer may simply function as a protective layer. A matting agent can be contained in the overcoating layer. The matting agent has a function of decreasing the adhesion of the overcoating layer. The matting agent has another function of increasing the vacuum contact of the layer with an original film when the plate is imagewise exposed to light through the original film.

An intermediate layer may be provided between any two layers, such as the support and the polymerizable layer, the support and the light-sensitive layer, the light-sensitive layer and the polymerizable layer and the light-sensitive layer and the ink-repellent layer. A primer layer (described below) is preferably provided on the support. Further, a layer provided under the light-sensitive layer (e.g., a polymerizable layer or an intermediate layer) preferably contains a coloring agent as an antihalation dye. The light-sensitive layer may also contain a coloring agent as an antiirradiation dye.

These layers may be formed by coating or lamination.

The presensitized lithographic plate preferably contains a base or base precursor, which accelerates the heat development of the silver halide. The base precursor is preferred to the base in view of the stability of the lithographic plate. The base or base precursor is preferably added to the light-sensitive layer or a layer adjacent to the light-sensitive layer (e.g., the polymerizable layer, a primer layer, the ink-repellent layer, an intermediate layer, a protective layer, an overcoating layer).

The support and the layers are described below in more detail.

### [Support]

The support should have such a flexibility that the plate can be set in a conventional printing machine. Further, the support should have such a strength that the plate bears a load in printing. Examples of the support include coated papers, metallic sheets (e.g., aluminum, sheet), plastic films (e.g., polyethylene terephthalate film), rubber sheets and a combination thereof.

### [Primer layer]

A primer layer may be provided on the support to improve the adhesion of the support and the other layers, to prevent halation, to dye the image or to improve the printing capabilities of the plate. The primer layer can be formed by coating a light-sensitive polymer on the support, irradiating the polymer with light and coating the other layers. The primer layer may also be formed by hardening an epoxy resin with heat. Further, the primer layer may be formed by hardening gelatin or casein. Furthermore, the primer layer may be made of a urethane resin. The primer layer may contain a polymer having a glass-transition point of not higher than room temperature to soften the layer. Examples of the polymer include polyurethane, polyimide, styrene-butadiene rubber, carboxyl denatured styrene-butadiene rubber, acrylonitrile-butadiene rubber, carboxyl denatured acrylonitrile-butadiene rubber, polyisopropylene, acrylate rubber, polyethylene, chlorinated polyethylene and chlorinated polypropylene. There is no specific limitation with respect to the amount of the polymer. The polymer itself may form the primer layer where the amount of the polymer is adjusted to form a film layer. The primer layer may further contain a dye, a pH indicator, a printing-out agent, an adhesive agent (e.g., a polymerizable compound, a diazo resin, a silane coupling agent, a titanate coupling agent, an aluminum coupling agent), a pigment, silicon powder, a reducing agent and a base or base precursor. The coating amount of the primer layer is preferably in the range of 0.1 to 20 g/m², and more preferably in the range of 1 to 10 g/m².

### [Light-sensitive layer]

The light-sensitive layer contains silver halide. The silver halide is preferably used in the form of an emulsion. The light-sensitive layer preferably contains a hydrophilic polymer as the binder of the silver halide. The light-sensitive layer may further contain a reducing agent and a base or base precursor. The coating amount of the silver halide is preferably in the range of 0.001 to 5 g/m², and more preferably in the range of 0.001 to 0.5 g/m² in terms of silver. The thickness of the light-sensitive layer is preferably in the range of 0.1 to 20 pm, and more preferably in the range of 0.5 to 10 µm.

### [Silver halide]

Examples of the silver halide include silver chloride, silver bromide, silver iodide, silver chlorobromide, silver chloroiodide, silver iodobromide and silver chloroiodobromide in the form of grains.

The silver halide grains may be of various crystal forms, for example, a regular crystal form such as hexahedron, octahedron or tetradecahedron, an irregular form such as spherical form or tabular form, a form having crystalline defect such as a twinning plane, and a mixed form thereof.

The silver halide grains may be extremely small sized grains having a grain diameter of not more than about 0.01 µm, or may be relatively large sized grains having a grain diameter of projected area of up to about 10 pm. The silver halide emulsion may be a polydispersed emulsion or a monodispersed emulsion as described in U.S. Patents No. 3,574,628 and No. 3,655,394, and U.K. Patent No. 1,413,748.

A tabular grain having an aspect ratio of not less than about 5 can be also employed. The tabular silver halide grains can be easily prepared by processes described in Gutoff, "Photographic Science and Engineering, Vol. 14, pp. 248-257 (1970)", US-A- 4,434,226, 4,414,310, 4,433,048 and 4,439,520, and GB-B- 2,112,157.

As for the crystal structure of the silver halide grains, the individual grains may have a homogeneous halogen composition or a heterogeneous halogen composition in which the composition varies from the outer surface portion to the inside portion, or may be a multi-layer structure. Otherwise, the silver halide grains may be bonded with other silver halide grains having different halogen composition through epitaxial bonding, or may be bonded with compounds other than the silver halide such as silver rhodanate and lead oxide.

Various substances in the form of salt can be added to the silver halide according to a conventional process at the grain formation or after the grain formation. Examples of the substances include copper, thallium, lead, cadmium, zinc, a chalcogen such as sulfur, selenium and tellurium, gold, and a group III noble metal such as rhodium, iridium, iron, platinum and palladium. The conventional process is described in US-A- 1,195,432, 1,191,933, 2,448,060, 2,628,167, 2,950,972, 3,488,709, 3,737,313, 3,772,031, 4,269,927 and "Research Disclosure" (RD), No. 13,452 (June, 1975).

In the case that the lithographic plate is exposed to light in a short time and at a high illuminance, iridium ions are preferably added to the silver halide in an amount of 10⁻⁸ to 10⁻³ mole, and more preferably in an amount of 10⁻⁷ to 10⁻⁵ mole based on 1 mole of silver halide.

Two or more kinds of silver halide grains which differ in halogen composition, crystal habit, grain size, and/or other features from each other can be employed in combination.

The silver halide is preferably used in the form of an emulsion.

The silver halide emulsion can be prepared by processes described, for example, in "Research Disclosure" (RD), No. 17,643, pp. 22-23 (Dec. 1978), (Emulsion preparation and types); and "Research Disclosure", No. 18,716, p. 648, (Nov. 1979).

The silver halide emulsion is generally used after subjecting it to physical ripening, chemical ripening and spectral sensitization. Various additives employable in those stages are described in "Research Disclosure", No. 17,643 and No. 18,716. The chemical sensitizing agent is described in No. 17,643 (p. 23) and No. 18,716 (p. 648, right side). The spectral sensitizing agent is described in No. 17,643 (pp. 23-24) and No. 18,716 (p. 648, right side). The supersensitizing agent is described in No. 18,716 (p. 649, right side). Other additives than the above-mentioned ones are also described in "Research Disclosure". For example, a sensitivity-increasing agent is described in No. 18,716 (p. 648, right side), and an antifogging agent and a stabilizer are described in No. 17,643 (pp. 24-25) and No. 18,716 (p. 649, right side), respectively.

It is preferred to use silver halide grains having a relatively low fogging value.

The silver halide emulsion may be a negative type. A reversal silver halide emulsion which directly forms a positive image can also be employed.

### [Organometallic salt]

In the invention, an organometallic salt can be used as an oxidizing agent in combination with the silver halide in the light-sensitive layer. An organosilver salt is particularly preferred.

As an organic compound employable for forming the organosilver salt, there can be mentioned benzotriazoles described in US-A- 4,500,626 (pp. 52-53), aliphatic acids and other compounds. Also employable are silver salts of carboxylic acids having alkynyl group, such as silver phenylpropiolate described in JP-A- 60-113235 and acetylene silver described in JP-A- 61-249044 and 64-57256. The organosilver salt may be used in combination of two or more compounds.

The organosilver salt is generally used in an amount of 0 to 10 moles, preferably 0 to 1 mole per 1 mole of silver halide. The organosilver salt may be formed in the lithographic plate by adding the above-mentioned organic compound the light-sensitive layer to cause a reaction of the compound with silver halide.

### [Hydrophilic polymer]

A hydrophilic polymer may be contained in the light-sensitive layer as a binder. The hydrophilic polymer preferably is soluble in water or swells in water. The hydrophilic polymer has a hydrophilic group or a hydrophilic bond in its molecule. Examples of the hydrophilic group include carboxyl, hydroxyl (including alcohol and phenol), sulfo, sulfonamido, sulfonimido and amido. Examples of the hydrophilic bond include urethane bond, ether bond and amido bond. The polymer which swells in water has an affinity to water, but is not soluble in water because of the cross-linking structure of the polymer. The molecular weight of the polymer is preferably in the range of 3,000 to 500,000.

The natural or synthetic polymers can be used as the hydrophilic polymer. Examples of the natural hydrophilic polymer include polysaccharide such as starch derivatives, cellulose derivatives, alginic acid, pectic acid, gum arabic and pullulan, and protein such as casein and gelatin. The denatured polymers can also be used. In preparation of the presensitized lithographic plate (at the stage of coating or drying), these natural polymers can be denatured or cross-linked. The synthetic hydrophilic polymer is a polymer or copolymer of water-soluble monomers. The water-soluble monomers have a hydrophilic group such as carboxyl, acid anhydride, hydroxyl, sulfo (which includes a salt thereof), amido, amino and ether. Examples of the monomer are described in "Application and Market of Water-soluble Polymer" (CMC, p. 16-18). A copolymer formed from the above-mentioned monomers by polymerization or cross-linking (cf., copolymers described in US-A- 4,913,998) is also available.

The other examples of the hydrophilic polymer include polyvinyl alcohol, polyvinyl ether, polyvinyl pyrrolidone and derivatives thereof. Polyvinyl alcohol is particularly preferred. Polyvinyl alcohol may be denatured by copolymerization with another monomer. A copolymer of vinyl acetate and another monomer is saponified to form the denatured polyvinyl alcohol. Examples of the monomer copolymerized with the vinyl acetate include ethylene, a higher vinyl carboxylate, a higher alkyl vinyl ether, methyl methacrylate and acrylamide. Polyvinyl alcohol may also be denatured after the saponification. The hydroxyl group in polyvinyl alcohol can be modified by etheration, esterification or acetalation. A cross-linked polyvinyl alcohol is also available. Examples of the cross-linking agent include aldehyde, methylol compounds, diisocyanate, divinyl compounds, dicarboxylic acids, borates, titanium and copper. The denatured or cross-linked polyvinyl alcohol is described in "Poval" 3rd ed., Kobunshi Kanko-Kai, p. 281-285.

A water-soluble polymer having a thioether bond in its side chain (cf., US-A- 3,615,624) is also available as the hydrophilic polymer.

The hydrophilic polymer is preferably used in an amount in the range of 0.05 g to 20 g/m², more preferably in the range of 0.1 to 10 g/m², and most preferably in the range of 0.3 to 3 g/m².

### [Polymerizable layer]

The polymerizable layer contains an ethylenically unsaturated polymerizable compound or a cross-linkable polymer. The layer may further contain a polymer which has a function of forming a film. A cross-linkable polymer having an ethylenically unsaturated group in its side chain is also available. The polymerizable layer may further contain a reducing agent and a base or base precursor.

### [Polymerizable compound]

The polymerizable compound contained in the polymerizable layer has an ethylenic unsaturated group.

Examples of the ethylenically unsaturated compounds include:
(A) Acrylic or methacrylic esters of alcohols such as ethanol, propanol, hexanol, octanol, cyclohexanol, glycerin, trimethylolpropane, pentaerythritol, ethylene glycol, propylene glycol, diethylene glycol, triethylene glycol, polyethylene glycol, polypropylene glycol, sugar alcohols (e.g., sorbitol, mannitol, dulcitol) and ethylene glycol derivatives thereof;
(B) Glycidyl acrylate, glycidyl methacrylate or allyl glycidyl of amines such as methylamine, ethylamine, butylamine, benzylamine, ethylenediamine, hexylenediamine, diethylenetriamine, hexamethylenediamine, xylilenediamine, dimethylamine, diethylamine, ethanolamine, diethanolamine and aniline;
(C) A reaction product of glycidyl acrylate, glycidyl methacrylate, allyl glycidyl or tetraglycidyl metaxylenediamine with carboxylic acids such as acetic acid, propionic acid, benzoic acid, acrylic acid, methacrylic acid, succinic acid, maleic acid, phthalic acid, tartaric acid and citric acid;
(D) Amide derivatives such as acrylamide, methacrylamide, N-methylolacrylamide and methylenebisacrylamide; and
(E) A reaction product of acrylic or methacrylic acid with an epoxy compound.

Examples of the compound further include urethane acrylates JP-A- 48-41708, No. 50(1975)-6034 and JP-A-(51-37193), polyester acrylates or polyfunctional acrylates or methacrylates such as epoxyacrylates formed by a reaction of an epoxy resin with acrylic or methacrylic acid JP-A- 48-64183, JP-B-49(1974)-43191 and 52(-30490) and N-methylol acrylamide (US-A- 4,540,649). Further, a photosetting monomer or oligomer (cf., Japan Adhesive Associate, Vol., 20, No. 7, p. 300-308 (1984)).

The polymerizable compound is commercially available. Examples include Alonix M-309, M-310, M-315, M-400, M-6100, M-8030, M-8100 (trade names of Toa Gosei Kagaku Kogyo Co., Ltd.); Kayarad HX-220, HX-620, R-551, TMPTA, D-330, DPHA, DPCA-60, R604, R684 (trade names of Nippon Kayaku Co., Ltd.); NK Ester A-1000, A-600, A-400, A-200, 14G, 23G (trade names of Shin-Nakamura Chemicals Co., Ltd.); and SARTOMER-454 and -9035 (SARTOMER Co., Ltd.).

The polymerizable layer may further contain a water-soluble compound and a water-insoluble binder polymer. The water-soluble compound causes a phase separation from the water-insoluble binder polymer, and forms a high density layer along the interface between the polymerizable layer and the ink-repellent layer. In this case, the ink-repellent layer within the unhardened area (where the polymerizable layer does not adhere to the ink-repellent layer) can be removed (etched) with water or an aqueous solution without use of an organic solvent. The water-soluble compound may be different from the polymerizable compound. However, the water-soluble compound preferably is an ethylenically unsaturated polymerizable compound. The compound preferably has two or more ethylenically unsaturated groups.

A hydrophobic polymerizable compound may be preferably used in combination with the above-mentioned water-soluble polymerizable compound. The hydrophobic or water-soluble polymerizable compound may have two or more unsaturated groups selected from acryl, methacryl and allyl groups. Tow or more polymerizable compounds can be used in combination.

The amount of the polymerizable compound and the water-soluble compound is preferably in the range of 5 to 80 % by weight, and more preferably in the range of 30 to 70 % by weight, based on the total amount of the polymerizable layer. The ratio of the water-soluble compound to the hydrophobic polymerizable compound is preferably in the range of 1:10 to 10:1.

### [Binder polymer (Cross-linkable polymer)]

The binder polymer contained in the polymerizable layer preferably has a film forming function. The polymer also preferably is water-insoluble. The molecular weight of the polymer is preferably in the range of 5,000 to 1,000,000, and more preferably in the range of 8,000 to 500,000. Examples of the polymer include polyester resin, vinyl chloride-vinyl acetate copolymer, acryl resin, vinyl chloride resin, vinylidene chloride copolymer, polyamide resin, epoxy resin, acrylate or methacrylate copolymer, polyurethane resin, vinyl chloride copolymer, polyvinyl butyral, polyvinyl formal, chlorinated polyethylene, chlorinated polypropylene, polycarbonate, cellulose polymers (e.g., acetyl cellulose, ethyl cellulose). The polymer may be a cross-linkable polymer which has an ethylenically unsaturated group in its side chain. Examples of the cross-linkable polymer include a homopolymer or copolymer of allyl acrylate or allyl methacrylate.

The binder polymer is preferably used in an amount of 10 to 90 % by weight, and more preferably in an amount of 25 to 70 % by weight, based on the total amount of the polymerizable layer.

### [Other components of the polymerizable layer]

The polymerizable layer may further contain a surface active agent, which is disclosed in US-A- 3,787,351, 4,487,823 and 4,822,713. The layer may contain a conventional thermal polymerization inhibitor such as hydroquinones, phenols, nitrobenzenes and tertiary aminophenothiazine.

The polymerizable layer may be formed by coating a sc lution of the above-mentioned components. Examples of the solvent of the solution include 2-methoxyethanol, 2-methoxyethylacetate, methyl lactate, ethyl lactate, propylene glycol monomethyl ether, methanol, ethanol, methyl ethyl ketone, water and a mixture thereof. The thickness of the polymerizable layer is preferably in the range of 0.1 to 10 µm, and more preferably in the range of 0.5 to 5 µm,

### [Ink-repellent layer]

The ink-repellent layer preferably contains a cross-linked silicone rubber or a cross-linked fluororesin.

The cross-linked silicone rubber is made by cross-linking polyorganosiloxane. The cross-linking may be partially introduced into the rubber. The rubber has the fol lowing repeating unit.

-Si(R)₂-O-

In the formula, R is a monovalent group selected from alkyl, aryl, alkenyl and a combination thereof. These groups may be substituted with a halogen atom, amino, hydroxy, alkoxy, aryloxy, acryloxy, methacryloxy or thiol. The silicone rubber layer may further contain inorganic particles (e.g., silica, calcium carbonate, titanium dioxide) or an adhesive agent (e.g., silane coupling agent, ti tanate coupling agent, aluminum coupling agent).

The silicone rubber is made by cross-linking polysiloxane which has a molecular weight of 1,000 to 1,000,000, and has a terminal functional group. In more detail, the polysiloxane has a hydroxy group at both or one of the two terminals. The polysiloxane is reacted with a silane cross-linking agent while heating or at room temperature. The silicone rubber layer is formed from the condensation reaction of the polysiloxane. A catalyst may be used in the reaction. Examples of the catalyst include organometallic compound (e.g., organotin compound), inorganic acid and amine. The silane cross-linking agent is represented by the following formula.

RₙSiX₄₋ₙ

In the formula, n is 1, 2 or 3; R has the same meaning as R defined in the previous formula; X is a substituent group such as -OH, -OR², -OCOCH₃, -O-N=CR²R³, -Cl, -Br or -I, wherein R² and R³ have the same meaning as R defined in the previous formula. R² and R³ may be different from each other.

The silicone rubber layer may also be formed by a condensation reaction of the polysiloxane having a terminal hydroxyl group.with a hydrogenpolysiloxane cross-linking agent. The above-mentioned silane cross-linking agent may additionally be used in this reaction.

Further, the silicone rubber layer may be formed by an addition reaction. In the addition reaction, the cross-linking structure is introduced by a group of ≡SiH or a group of -CH=CH-. The addition type silicone rubber layer has some advantages that the hardening reaction is rather resistant to the influence of the moisture, that the cross-linking reaction can proceed at a high temperature, and that the physical property can easily be adjusted.

The addition type silicone rubber layer is formed by a reaction of polyfunctional hydrogenorganopolysiloxane with a polysiloxane compound having two or more bonds of -CH=CH-in its molecule. The layer is preferably formed by a cross-linking and hardening reaction of the following composition.
(1) An organopolysiloxane having at least two alkenyl groups (preferably vinyl group) which are directly attached to silicon 100 weight parts
(2) An organohydrogenpolysiloxane having at least two SiH bonds in its molecule
   0.1 to 1,000 weight parts; and
(3) An addition catalyst
   0.00001 to 10 weight parts

The alkenyl group of the component (1) may be attached to a terminal group or a linking group of the organopolysiloxane. The other organic groups such as an alkyl group or an aryl group may be attached to the component (1). The alkyl or aryl group may be further substituted with another organic group. The component (1) may further contain a small amount of hydroxyl group. The component (2) has a function of making the silicone rubber layer adhesive to the polymerizable layer, when the rubber layer is formed by the reaction of the components (2) with (1). The hydrogen of the component (2) may be attached to a terminal group or a linking group of the organohydrogenpolysiloxane. The other organic groups described above with respect to the component (1) may be attached to the component (2). At least 60 % (number of the groups) of the organic groups of the components (1) and (2) preferably are methyl groups to improve the ink-repellency of the silicone rubber layer. There is no specific limitation with respect to the molecular structures of the components (1) and (2). Any structures of a straight chain, a cyclic chain and a branched chain are available. At least one of the components (1) and (2) preferably has a molecular weight of not less than 1,000 to improve the characteristics of the rubber. It is more preferred that the component (1) has a molecular weight of not less than 1,000.

Examples of the component (1) include α,ω-di-vinylpolydimethylsiloxane and methylvinylsiloxane/dimethylsiloxane copolymer having methyl groups at the terminal ends. Examples of the component (2) include polydimethylsiloxane having hydroxyl groups at the terminal ends, α,ω-dimethylplymethylhydrogensiloxane, methylhydrogensiloxane/dimethylsiloxane copolymer having methyl groups at the terminal ends and cyclic polymethylhydrogensiloxane.

The addition catalyst of the component (3) has been well known. A platinum compound is preferably used as the catalyst. Examples of the platinum catalyst include metallic platinum, platinum chloride, chloroplatinic acid and olefin platinum complex. A cross-linking regulator may be added to the composition to adjust the rate of the hardening reaction. Examples of the regulator include organosiloxane having vinyl group (e.g., tetracyclo (methylvinyl) siloxane), acetylene alcohol, acetone, methyl ethyl ketone, methanol, ethanol and propylene glycol monomethylether.

The addition reaction of the above-mentioned composition initiates hardening when the three components are mixed. Raising the reaction temperature greatly increases the hardening rate. Accordingly, the hardening conditions of the composition are preferably adjusted at a high temperature to bind the rubber layer steadily to the polymerizable layer. If the high temperature is employed in the hardening reaction, the pot life from the composition to the rubber is increased and the hardening time on the layer is decreased. Therefore, the high temperature is preferably kept to finish the hardening reaction so long as the characteristics of the polymerizable layer or the plate are not changed at the temperature.

In addition to the above-mentioned composition, a known adhesive agent such as an alkenyltrialkoxysilane may be added to the rubber layer. Further, the rubber layer may contain hydroxyorganopolysiloxane (a component of a condensed silicone rubber layer), dimethylpolysiloxane having a trymethylsilyl terminal group, silicone oil consisting of a phenylmethylpolysiloxane copolymer or a silane or siloxane having a functional group which may be hydrolyzed Furthermore, a conventional packing agent such as silica may be added to the layer to improve the strength of the rubber.

Examples of the alkenyltrialkoxysilane are shown below.

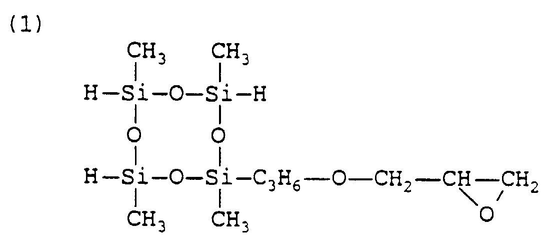

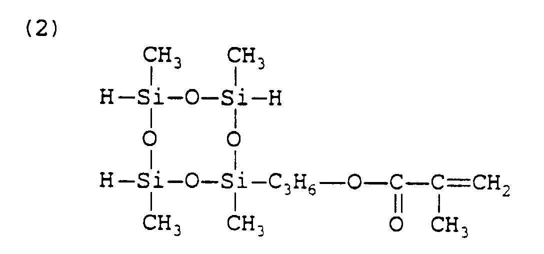

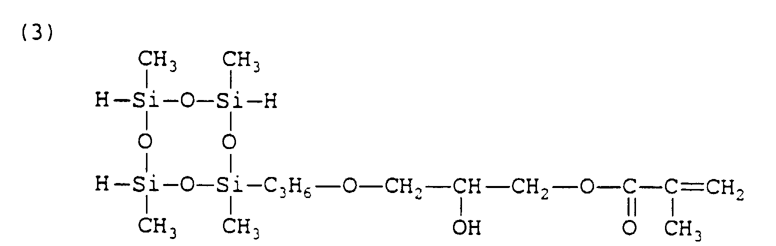

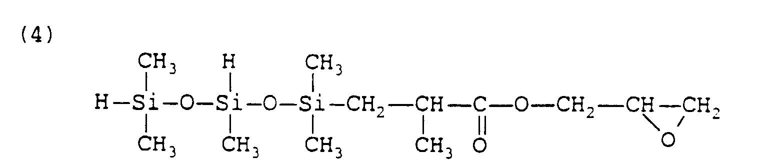

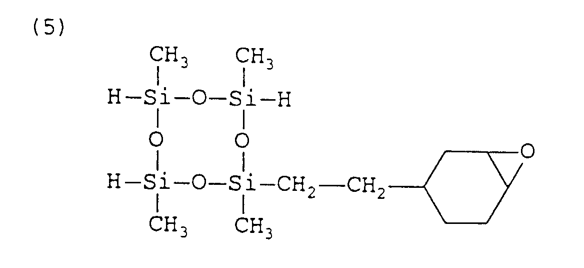

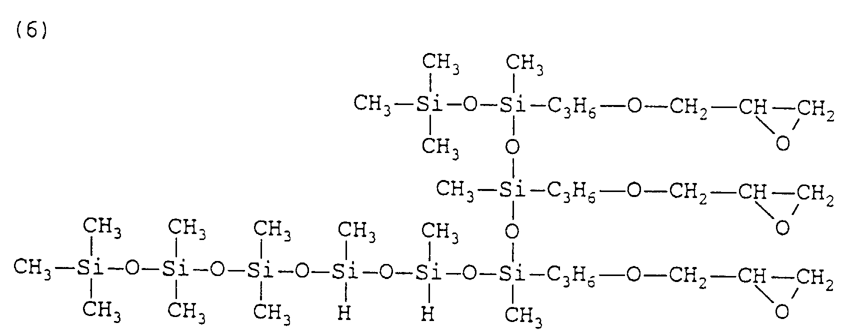

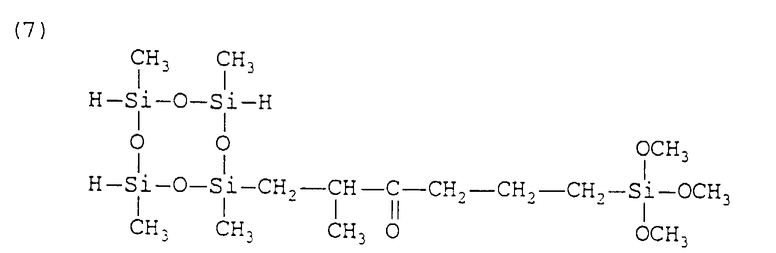

The cross-linked fluororesin layer is described in JP-A- 58- 215411 and 2-103047. The fluororesin contains a partial structure such as CF₃-, -CF₂-, -CF-, CF₃-O-, CF₂-O- and -CF-O- in its molecule. The content of fluorine in the molecule is not less than 30 wt.%, and preferably not less than 50 wt.%. The fluororesin further contains a functional group which reacts with a cross-linking agent, or another functional group such as -OH, -COOH, -NH₂, 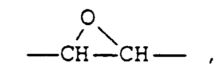 -NCO and -NH-. The fluororesin may be prepared by copolymerization of an acryl or methacryl monomer containing fluorine or an olefin monomer containing fluorine with an acryl or methacryl monomer or a vinyl monomer.

If the ink-repellent layer is formed as a thin layer, there is a problem of a mechanical strength. If a thick layer is formed, it is difficult to remove (etch) the ink-repellent layer within the unhardened area. The thickness of the ink-repellent layer is preferably in the range of 0.5 to 5 g/m², and more preferably in the range of 1 to 3 g/m².

The ink-repellent layer may comprise two or more layers. An adhesive layer may be provided between the ink-repellent layer and the polymerizable layer to improve the adhesion between the layers. The adhesive layer may have another function of protecting the catalyst in the ink-repellent layer. A film may be laminated or coated on the ink-repellent layer to protect the layer. The protective film can be made of polyethylene, polypropylene, polyvinyl chloride, polyvinylidene chloride, polyvinyl alcohol, polyethylene terephthalate or cellophane. The film can be used after drawing elongation.

### [Reducing agent]

The reducing agent has a function of reducing the silver halide and/or a function of accelerating (or inhibiting) polymerization of the polymerizable compound. There are known various reducing agents having the above-mentioned functions. Examples of such reducing agents include hydroquinones, catechols, p-aminophenols, p-phenylenediamines, 3-pyrazolidones, 3-aminopyrazoles, 4-amino-5-pyrazolones, 5-aminouracils, 4, 5-dihydroxy-6-aminopyrimidines, reductones, aminoreductones, o- or p-sulfonamidophenols, o-or p-sulfonamidonaphthols, 2,4-disulfonamidephenols, 2,4-disulfonamidenaphthols, o- or p-acylaminophenols, 2-sulfonamidoindanones, 4-sulfonamido-5-pyrazolones, 3-sulfonamidoindoles, sulfonamidopyrazolobenzimidazoles, sulfonamidopyrazolotriazoles, α-sulfonamidoketones and hydrazines.

Various reducing agents having the above-mentioned functions (including compounds referred to as developing agent or hydrazine derivative) are described in JP-A- 61-183640, 61-183535, 61-228441, 62-70836, 61-86354, 62-86355, 62- 206540, 62-264041, 62-109437 and 63-254442, and JP-A- 63-97379, 63-296774, 63-296775, 1-27175, 1-54101 and 1-91162. These reducing agents are also described in T. James, "The Theory of the Photographic Process", 4th edition, pp. 291-334 (1977), "Research Disclosure", Vol. 170, No. 17029, pp. 9-15 (June 1978), and "Research Disclosure", Vol. 176, No. 17643, pp. 22-31 (December 1978). Further, there can be also employed a reducing agent precursor capable of releasing a reducing agent under heating or in contact with a base. Also in the presensitized lithographic plate of the invention, various reducing agents and reducing agent precursors described in the above publications, applications and literatures can be effectively employed. Thus, "the reducing agent(s)" in the present specification means to include all the reducing agents and reducing agent precursors described in the above publications.

When the reducing agent is basic, that is, it forms a salt with an acid, the reducing agent can be used in the form of a salt of an appropriate acid. These reducing agents can be used singly or in combination. In the case that two or more reducing agents are used in combination, certain interactions between those reducing agents may be expected. One of the interactions is an acceleration of reduction of silver halide (and/or an organosilver salt) through so-called superadditivity. Another interaction is a chain reaction in which an oxidant of one reducing agent formed by a reaction with silver halide (and/or an organosilver salt) induced or inhibits the polymerization of the polymerizable compound by oxidation-reduction reaction with other reducing agent. Both interactions may occur simultaneously. Thus, it is difficult to determine which of the interactions has occurred in practical use.

The reducing agent is used in an amount of 0.1 to 10 mole and more preferably 0.5 to 5 mole per 1 mole of the silver halide.

Examples of the reducing agents are shown below.

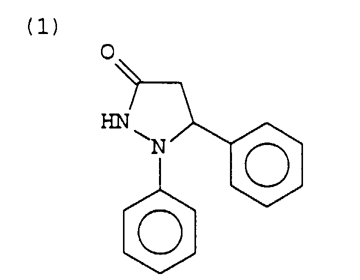

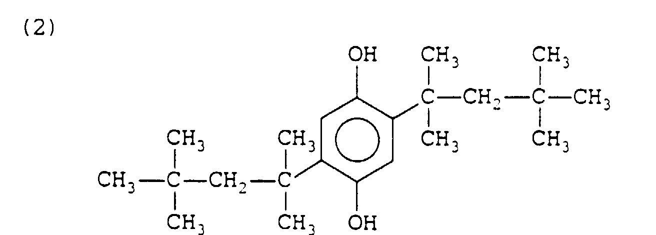

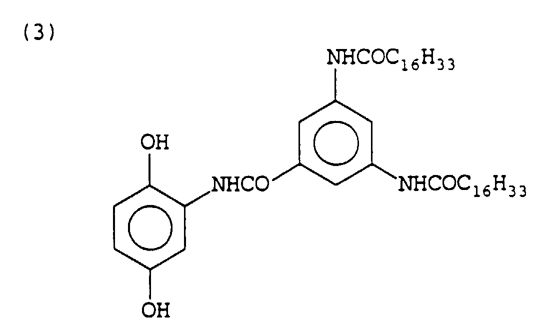

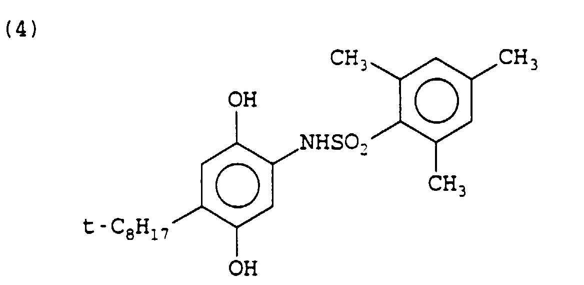

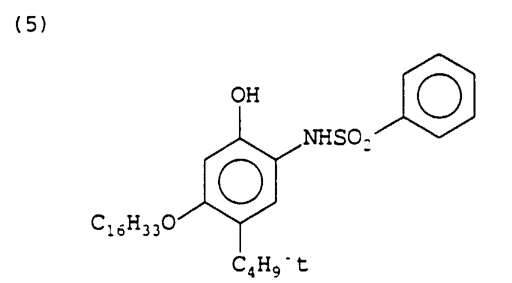

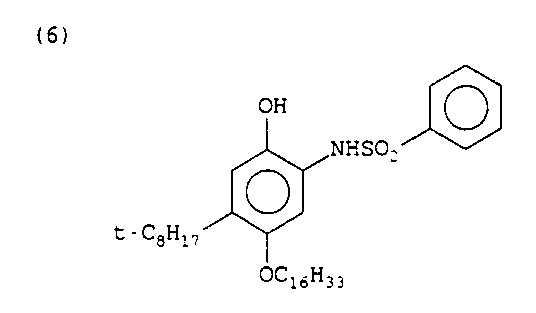

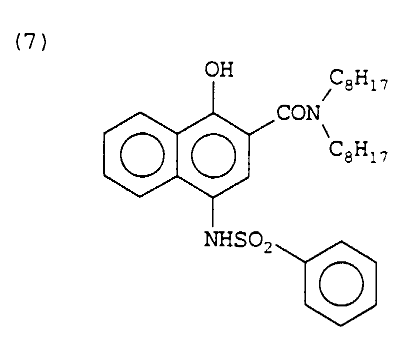

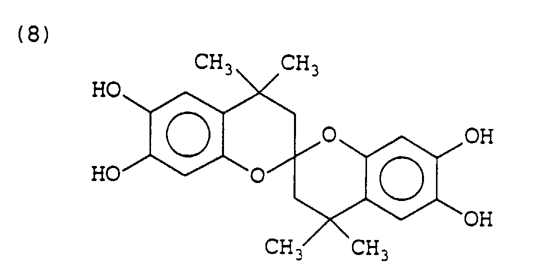

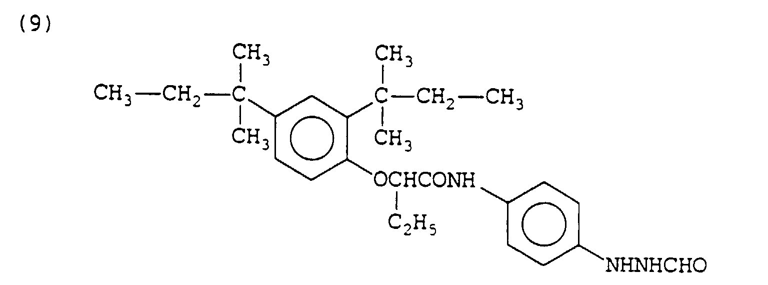

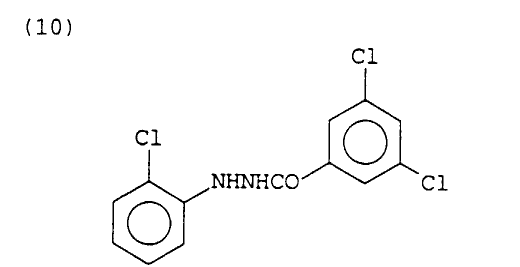

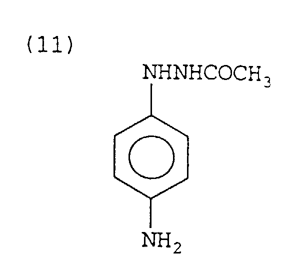

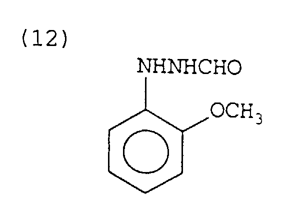

By adjusting the kind or amount of the above reducing agent, the polymerizable compound can be polymerized within the area where a latent image of the silver halide has been formed or within the area where a latent image of the silver halide has not been formed.

When hydrazines are used as the reducing agent singly or in combination with other reducing agent, the polymerizable compound is polymerized within the area where a latent image of the silver halide has been formed. When 1-phenyl-3-pyrazolidones, hydroquinones and sulfonamidophenols are used as the reducing agent and hydrazines are not used in combination, the polymerizable compound is polymerized within the area where a latent image of the silver halide has not been formed. In this case, however, it is required to incorporate a polymerization initiator which is decomposed under heating or light-irradiation to generate radical into the light-sensitive layer or the polymerizable layer.

### [Polymerization initiator]

A thermal polymerization initiator is described in "Addition Polymerization and Ring Opening Polymerization", pp. 6-18, edited by the Editorial Committee of High Polymer Experimental Study of the High Polymer Institute, published by Kyoritsu Shuppan (1983) and JP-A- 61-243449. Examples of the thermal polymerization initiators include azo compounds such as azobis (isobutyronitrile), 1,1'-azobis(1-cyclohexanecarbonitrile) and dimethyl 2,2'-azobisisobutyrate; and peroxides such as benzoyl peroxide and potassium persulfate.

The photopolymerization initiator is described in Oster et al., Chemical Review, vol. 68, p. 125-151 (1968) and Kosar, Light-Sensitive System, p. 158-193, John Wiley & Sons (1965) and JP-A- 61-75342 and 2-207254. Examples of the photopolymerization initiator include carbonyl compounds (e.g., benzophenones, acetophenones, quinones, Irgacure-651™ and Irgacure-907™ (produced by Ciba Geigy)), halogen-containing compounds, redox couples of a photo-reducible dye and a reducing agent, organic sulfur compounds, peroxides, photo semi-conductors and metallic compounds.

The polymerization initiator is used in an amount of preferably 0.001 to 0.5 g, and more preferably 0.01 to 0.2 g, per 1 g of the polymerizable compound.

### [Base and base precursor]

Examples of the base and base precursor include inorganic or organic bases and their base precursors (e.g., decarboxylation type, thermal decomposition type, reaction type and complex salt-formation type).

The inorganic bases are described in JP-A- 62-209448. The organic bases include tertiary amine compounds described in JP-A- 62-170954; bisamidine compounds, trisamidine compounds or tetraamidine compounds described in JP-A- 63-316760; and bisguanidine compounds, trisguanidine compounds or tetraguanidine compounds described in JP-A- 64-68746. In the invention, a base of not less than pKa 7 is preferred.

In the present invention, a base precursor is preferably employed from the viewpoint of storage stability of the presensitized lithographic plate.

Preferred examples of the base precursors include salts of bases with organic acids which are decarboxylated under heating described in JP-A- 63-316760, 64-68746, 59-180537 and 61-313431; and urea compounds which release bases under heating described in JP-A- 63-96159. Examples of processes for making the base precursor release a base through a certain reaction include a process comprising utilizing a reaction between the base precursor and a salt containing anion having higher compatibility with transition metal acetylide or transition metal ion than acetylide anion, as described in JP-A- 63-25208; and a process comprising introducing into water both of a basic metallic compound which is hardly dissolved in water and a compound capable of reacting with metal ion of the basic metallic compound in a water medium to form a complex salt so as to release a base through a reaction between those two compounds in the presence of water, described in JP-A- 1-3282.

The base precursor employable in the invention preferably releases a base at a temperature ranging from 50 to 200 °C, more preferably from 80 to 180 °C.

The light-sensitive material employing a base or a base precursor is described in JP-A- 62-264041. A light-sensitive material employing a tertiary amine as a base is described in JP-A- 62-170954. A light-sensitive material employing dispersed grains of a hydrophobic organic base compound having a melting point of 80 to 180 °C is described in JP-A-62-209523. A light-sensitive material employing a guanidine derivative having a solubility of not more than 0.1 % is described in JP-A-63-70845. A light-sensitive material employing hydroxides or salts of alkali metals or alkaline earth metals is described in JP-A- 62-209448.

A light-sensitive material employing acetylide compounds as a base precursor is described in JP-A-63-24242. A light-sensitive material employing salts of propiolic acid as a base precursor and further containing silver, copper, a silver compound or a copper compound as a catalyst of the base production reaction is described in 63-46446. A light-sensitive material containing the salts of propiolic acid under the condition of being separated from the silver, copper, silver compound or copper compound is described in JP-A-63-81338. A light-sensitive material containing free ligands in addition to the salts of propiolic acid and the silver, copper, silver compound or copper compound is described in JP-A-63-97942. A light-sensitive material employing salts of the propiolic acid as a base precursor and further containing heat fusible compounds as an accelerator of the base production reaction is described in JP-A-63-46447. A light-sensitive material employing a salt of sulfonyl acetate as a base precursor and further containing heat fusible compound as an accelerator for the base production reaction is described in JP-A-63-48453. A light-sensitive material employing compounds in which isocyanate or isothiocyanate is bonded to an organic base is described in JP-A- 63-96652. A light-sensitive material containing a nucleating agent as a decomposition accelerator of the above compounds is described in JP-A- 63-173039.

A light-sensitive material employing as a base precursor a bisamidine or trisamidine salt of a carboxylic acid capable of being decarboxylated is described in Japanese Patent Provisional Publication No. 64(1989)-9441. A light-sensitive material employing as a base precursor a bisguanidine or trisguanidine salt of a carboxylic acid capable of being decarboxylated is described in JP-A-64-68749.

The base or the base precursor can be used in an amount of preferably 0.5 to 50 mole(s), more preferably 1 to 20 mole(s), per 1 mole of the silver halide. [Heat development accelerator]

A heat development accelerator may be added to a layer of the plate, preferably to the light-sensitive layer, the polymerizable layer, the overcoating layer or the intermediate layer. The heat development accelerator serves to accelerate thermal decomposition of the base precursor or to accelerate development of the silver halide by dissolving the base or the reducing agent in the heating procedure.

The heat development accelerator has been known as a thermal solvent. Examples of the heat development accelerator known as the thermal solvent include polyethylene glycols, sulfonamides and cyclic amides, which are described in US-A-3,347,675, No. 3,667,959, "Research Disclosure" pp. 26-28, (Dec. 1976), JP-A-62-151841, 62-151743, 62-183450, 63-243835 and 63-253934.

The heat development accelerator also has a function of increasing the plasticity of a polymer (which functions as a polymer binder, and is contained in the polymerizable layer, the light-sensitive layer or other layers) at a room temperature or at a heat development process. The heat development accelerator has been known as a plasticizer. The known plasticizers are described in "Plastic Additives (written in Japanese)", p. 21-63 (Taisei-sha); Plastics Additives, Second Edition; Hanser Publishers, Chapter 5, p. 251-296; Thermoplastic Additives, Marcel Dekker Inc., Chapter 9, p. 345-379; Plastic Additives, An Industrial Guide, Noyes Publications, Section 14, p. 333-485: The Technology of Solvents and Plasticizers, John Wiley & Sons Inc., Chapter 15, p. 903-1027; Industrial Plasticizers, Pergamon Press; Plasticizer Technology, Vol. 1, Reinhold Publishing corp.; and Plasticization and Plasticizer Process, American Chemistry.

It is sometimes difficult to determine the function of the heat development accelerator. Further, some accelerators have both of the above-mentioned two functions.

Examples of the preferred heat development accelerators include ureas such as urea, ethyleneurea, methylurea, dimethylurea, ethylurea and propyleneurea, amides such as acetamide and propionamide, sulfamides, sulfonamides, a polyhydric alcohol such as sorbitol, trimethylolethane, trimethylolpropane, pentaerythritol, glycerin, ethylene glycol, propylene glycol, butanediol and hexanediol, a urea resin, a phenol resin. Two or more heat development accelerators can be used in combination.

### [Colored substance]

The layers of the lithographic plate may be colored with a colored substance. There is no specific limitation on the colored substance (i.e., coloring matter), and any known pigments and dyes can be employed. The coloring matter also serves as an antihalation agent, so that it is contained in a layer arranged between the support and the light-sensitive layer (e.g., the polymerizable layer, the intermediate layer, the primer layer). The coloring matter can also be contained in the light-sensitive layer for antiirradiation. The coloring matter used for antihalation or antiirradiation preferably adsorbs the light within the spectral region of silver halide.

The pigments used in the invention can be selected from those commercially available and those described in various publications such as "Handbook of Color Index", "New Handbook of Pigments", (Nippon Ganryo Gijutsu Kyokai (ed.,), 1977), "New Applied Technique of Pigments", (CMC Publishing, 1986), and "Technique of Printing Ink", (CMC Publishing, 1984).

Examples of the pigments include black pigments, yellow pigments, orange pigments, brown pigments, red pigments, violet pigments, blue pigments, green pigments, fluorescent pigments, metal powder pigments and polymer pigments. Concrete examples of the pigments include insoluble azo pigments, azo lake pigments, condensation azo pigments, chelate azo pigments, phthalocyanine pigments, anthraquinone pigments, perylene pigments, perynone pigments, thioindigo pigments, quinacridone pigments, dioxazine pigments, isoindolinone pigments, quinophthalone pigments, dye-type lake pigments, azine pigments, nitroso pigments, nitro pigments, natural pigments, fluorescent pigments and inorganic pigments.

The pigment used in the invention can be per se used or can be used after being subjected to surface treatment. As the surface treatment, there can be employed a method of coating a resin or wax on the surface of the pigment, a method of depositing a surface active agent thereon, a method of bonding a reactive substance (e.g., silane coupling agent, epoxy compound and polyisocyanate) to the surface of the pigment. Those methods are described, for example, in "Nature and Application of Metal Soap", (Saiwai Shobo), "Technique of Printing Ink", (CMC Publishing, 1984), and "New Applied Technique of Pigments", (CMC Publishing, 1986).

The particle diameter of the pigment is preferably in the range of 0.01 to 10 µm, more preferably 0.05 to 1 µm. The pigment can be used by adding or dispersing it into a coating solution for the formation of a layer. For dispersing the pigment in the coating solution, various dispersing techniques conventionally used for the preparation of ink or toner can be employed. As the dispersing device, there can be used a sand mill, an attritor, a pearl mill, a super mill, a ball mill, an impeller, a disperser, a KD mill, a colloid mill, a dynatron a three-roll mill and a press kneader. Details of the devices are described in "New Applied Technique of Pigments", (CMC Publishing, 1986).

Dyes can be employed as the coloring matter. As the dye, that is, a material being itself colored, there can be used those commercially available and those described in various publications (e.g., "Handbook of Dyes", Yuki Kagaku Kyokai (ed.), 1970). Concrete examples of the dyes include azo dyes, metal complex salt azo dyes, pyrazolone azo dyes, anthraquinone dyes, quinonimine dyes and methine dyes.

Antiirradiation dyes which does not affect the sensitivity of silver halide are described in JP-B-41-20389, 43-3504, 43-13168, JP-A-2-39042, US-A-3,697,037, 3,423,207 and 2,865,752, and GB-B-1,030,392 and 1,100,546.

The amount of the coloring matter to be contained in the polymerizable layer widely varies depending on the absorbance of the used coloring matter, but preferably is in the range of about 0.1 to 2 g/m², and more preferably in the range of 0.05 to 1 g/m². [antifogging agent, development accelerator and stabilizer]

The presensitized lithographic plate can contain various antifogging agents, development accelerators and stabilizers. Examples of them include azoles and azaindenes described in "Research Disclosure" pp. 24-25 (1978); carboxylic acids containing nitrogen and phosphoric acids containing nitrogen described in JP-A-59-168442; mercapto compounds and their metallic salts described in JP-A-59-111636; and acetylene compounds described in JP-A-62-87957. These compounds are generally employed in an amount of 10⁻⁷ to 1 mole per 1 mole of the silver halide.

### [Development stopping agent]

A variety of development stopping agents can be employed in the presensitized lithographic plate for constantly obtaining uniform images in spite of temperatures and time for the development process. The development stopping agents are compounds to neutralize a base or react with a base to reduce the base concentration in the layer to stop development, or compounds that mutually react with silver or a silver salt to suppress development, after the appropriate development. More specifically, examples of the development stopping agents include acid precursors capable of releasing acids upon heating, electrophilic compounds capable of undergoing substitution reaction with a coexisting base upon heating, nitrogen-containing heterocyclic compounds, mercapto compounds, and precursors thereof. Examples of the development stopping agents are described in detail in JP-A-62-253159 (pp. 31-32), and JP-A-1-72479 and 1-3471. The development stopping agent can be contained in any of the layers.

### [Surface active agent]

A surface active agent can be contained in each of the layers. Examples of the surface active agent include nonionic, anionic and cationic agent (disclosed in JP-A-2-195356). Sorbitan, polyoxyethylene and a fluorine-containing compound are preferred.

### [Matting agent]

A matting agent can be contained in the uppermost layer such as the overcoating layer or the image formation accelerating layer. The matting agent preferably is powder of a polymer. The polymer is a natural polymer such as starch or is a synthetic polymer such as polyethylene. The particle size of the powder is preferably in the range of 1 to 50 µm.

### [Polymerization inhibitor]

A polymerization inhibitor can be added to the polymerizable layer to inhibit polymerization while the presensitized lithographic plate is preserved. Conventional polymerization inhibitors such as nitrosoamines, thiourea compounds, thioamide compounds, urea compounds, phenol derivatives, nitrobenzene derivatives and amines are available. Examples of the polymerization inhibitors include aluminum salt of cupferron, N-nitrosodiphenylamine, allylthiourea, aryl phosphite, p-toluidine, φ-toluquinone, nitrobenzene, pyridine, phenathiazine, β-naphthol, naphthylamine, t-butylcatechol, phenothiazine, chloranil, p-methoxyphenol, pyrogallol, hydroquinone and alkyl or aryl substituted hydroquinone.

### [Overcoating layer and intermediate layer]

An overcoating layer may be provided as the uppermost layer to prevent oxygen from permeating the lithographic plate at the heat development. The oxygen has a function of inhibiting the polymerization reaction. The overcoating layer contains a hydrophilic binder polymer, which is described with respect to the binder of the light-sensitive layer. The binder polymer preferably has a low transmission coefficient of oxygen. The coefficient preferably is not more than 1.0 × 10⁻¹¹ cc·cm/cm²·sec·cmHg. The examples of the hydrophilic polymer binder having the low transmission coefficient of oxygen include polyvinyl alcohol and its derivatives and gelatin. The derivatives of polyvinyl alcohol include the denatured polyvinyl alcohol (formed by saponification of the block copolymer of polyvinyl acetate and another monomer). The molecular weight is preferably in the range of 3,000 to 500,000.

Polyvinyl alcohol preferably has a high saponification degree of not less than 70 %, more preferably of not less than 80 %, most preferably of not less than 95 %. A copolymer of polyvinylidene chloride, which has a low transmission coefficient of oxygen is also available. A plastic film may be laminated on the uppermost layer in place of the overcoating layer. The film may be made of polyethylene terephthalate, polyurethane, polyvinylidene chloride, cellophane or polyvinyl alcohol.

The thickness of the overcoating layer is preferably in the range of 0.5 to 10 µm.

The uppermost layer such as the overcoating layer or the protective layer may contain a matting agent. The matting agent preferably is powder of a polymer. The polymer is a natural polymer such as starch or is a synthetic polymer such as polyethylene. The particle size of the powder is preferably in the range of 1 to 50 µm.

There is no specific limitation with respect to the intermediate layer. The intermediate layer may be formed from the hydrophilic polymer used in the light-sensitive layer or the overcoating layer or from the binder polymer used in the polymerizable layer. The thickness of the intermediate layer depends on its function. The thickness is generally not more than 10 µm.

The above-mentioned overcoating layer, the intermediate layer or the primer layer may contain reducing agent, a base or base precursor, a heat development accelerator, an antihalation dye, a polymerization initiator, an antifogging agent, a development accelerator, a stabilizer, a development stopping agent or a surface active agent.

### [Process for preparation of plate]

A process for the preparation of a lithographic print ing plate comprises steps of: imagewise exposing to light the presensitized lithographic plate to form a latent image of silver halide; simultaneously or thereafter heating uniformly the plate to develop the silver halide in which the latent image has been formed and to polymerize the polymerizable compound (or to cross-link or harden the binder polymer) within the area where the latent image has been formed (or not formed); and removing the ink-repellent layer within the unhardened area (or the area where the polymerizable layer does not adhere to the ink-repellent layer) to form a waterless lithographic plate.

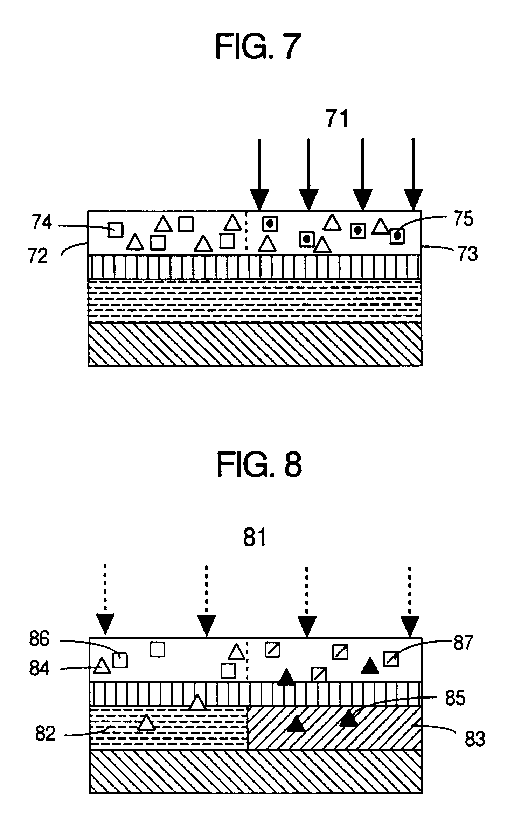

The steps of the process are described below referring to Fig. 7 to Fig. 9. In Fig. 7 to Fig. 9, the presensitized lithographic plate comprises a support, a polymerizable layer, an ink-repellent layer and a light-sensitive layer. This structure has been shown and described in Fig. 5.

Fig. 7 is a sectional view schematically illustrating the exposure step. As is shown in Fig. 7, a latent image is formed in the silver halide (75) within the area (73) exposed to light (71). On the other hand, the silver halide (74) within the unexposed area (72) is not changed.

Fig. 8 is a sectional view schematically illustrating the heat development step. As is shown in Fig. 8, when the presensitized lithographic plate is uniformly heated (81), the silver halide within the exposed area is developed with a reducing agent to form a silver image (87). Thus, a radical (85) is formed from the oxidation product of the reducing agent. The radical is transferred from the light-sensitive layer to the polymerizable layer. The polymerizable compound (83) is hardened by the function of the radical. On the other hand, the silver halide (86), the reducing agent (86) and the polymerizable compound (82) are substantially not changed within the unexposed area.

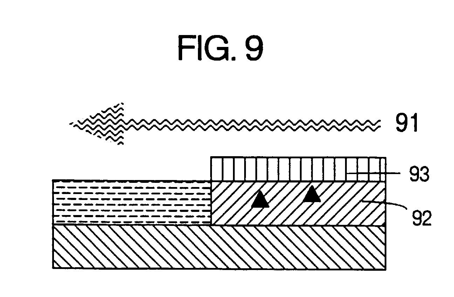

Fig. 9 is a sectional view schematically illustrating the step of removing the ink-repellent layer. After the heat development, the lithographic plate is treated with an etching solution (91). As a result, the ink-repellent layer on the unhardened polymerizable layer is removed from the plate. The hardened area of the polymerizable layer (92) and the ink-repellent layer thereon (93) remain, and form an ink-repellent area. All or a part of the unhardened polymerizable layer may be removed from the plate.

The exposure can be made using a light source capable of emitting a light corresponding to a spectral sensitivity (of sensitizing dye) of the silver halide. Examples of such light sources include various lamps (e.g., a tungsten lamp, a halogen lamp, a xenon lamp, a mercury lamp and a carbon arc lamp), various lasers (e.g., a semiconductor laser, a helium neon laser, an argon laser and a helium cadmium laser), light emission diode, and a CRT tube. A light for the exposure preferably is a visible light, a near ultraviolet ray or a near infrared ray. A X-ray and an electron beam are also available. The exposure is generally determined by a sensitivity of silver halide. The exposure amount is preferably in the range of 10⁻⁹ to 10⁻³ (0.01 to 10,000 ergs/cm²) more preferably 10⁻⁸ to 10⁻⁴ (0.1 to 1,000 ergs/cm²). In the case that the support is transparent, the presensitized lithographic plate can be exposed to light from the side of the transparent support.

The heat development can be conducted by bringing the lithographic plate into contact with a heated material (e.g., heated plate or roller), heating the lithographic plate by a radiation heat of an infrared rays lamp, or immersing the lithographic plate in a heated medium such as a heated oil. For preventing polymerization inhibition caused by the entered oxygen of air during the heating stage, the lithographic plate is preferably heated under such conditions that the surface of the lithographic plate is covered with a material that hardly transmits oxygen. For example, the surface of the lithographic plate is brought into close contact with a heated material. This is particularly preferred in the case that a protective film or an overcoating layer is not provided on the ink-repellent layer.

The temperature for the heating is preferably in the range of 60 to 200 °C, more preferably 80 to 200 °C. The heating time is preferably in the range of 0.5 to 180 seconds, and more preferably 3 to 60 seconds.

In the case that the polymer image is formed by using a polymerization inhibiting function of the reducing agent of an oxidation product thereof, it is necessary to form a radical uniformly from a polymerization initiator. Where a thermal polymerization initiator is used, additional heating step is not necessary since a radical is formed at the heat development. On the other hand, it is necessary to irradiate the plate uniformly with light to form a radical in the case that a photopolymerization initiator is used. The light source may be selected from those used in the imagewise exposure. The wave length of the light is determined based on the spectral sensitivity of the photopolymerization initiator. The amount of the light is usually in the range of (10⁻⁴ to 1 J) (10³ to 10⁷ ergs/cm²).

After the heat development, the plate is treated with an etching solution to remove (or etch) the ink-repellent layer within the image area. The etching solution has a function of dissolving or swelling all or a part of the image area (unhardened area) of the polymerizable layer or swelling all or part of the ink-repellent layer within the image area. Before the etching treatment, the layers provided on the ink-repellent layer (e.g., a light-sensitive layer, an overcoating layer, a protective layer) is preferably removed from the plate.

The etching solution has been known as a developing solution of a waterless lithographic plate. The solution preferably is a water or an aqueous solution of a water-soluble organic solvent. The amount of the organic solvent is preferably not more than 40 wt.% in the solution. An example of the solvent is a mixture of an aliphatic hydrocarbon (hexane, heptane, Isoper E, H or G (Esso Chemical Co., Ltd.), gasoline, kerosene), an aromatic hydrocarbon (e.g., toluene, xylene) or halogenated hydrocarbon (e.g., trichlene) with a polar solvent. The polar solvent itself may be used as the organic solvent. Examples of the polar solvent include alcohols (e.g., methanol, ethanol, propanol, isopropanol, benzyl alcohol, ethylene glycol monomethyl ether, 2-ethoxyethanol, diethylene glycol monoethyl ether, diethylene glycol, monohexyl ether, triethylene glycol monomethyl ether, propylene glycol monoethyl ether, dipropylene glycol monomethyl ether, polyethylene glycol, tetraethylene glycol), ketones (e.g., acetone, methyl ethyl ketone), esters (e.g., ethyl acetate, methyl lactate, butyl lactate, propylene glycol monomethyl ether acetate, diethylene glycol acetate, diethyl phthalate), triethylene phosphate, tricresyl phosphate and acetic acid.

Water may be added to the etching solution of the above-mentioned organic solvent. The organic solvent may be dissolved in water using a surface active agent to prepare an etching solution. The etching solution may further contain an alkaline agent (e.g., sodium carbonate, diethanolamine, sodium hydroxide). The water itself (distilled water, pure water, running water) may be used as the etching solution.

The etching solution may contain a dye (e.g., crystal violet, victoria pure blue, astrazone red) to dye the image simultaneously with the etching treatment. The etching treatment may be conducted by a conventional method. For example, the plate may be rubbed with an etching pad containing the etching solution. Further, the plate may be rubbed with a brush in water after the etching solution is poured on the surface of the plate. After the etching treatment, the ink-repellent layer within the image area is removed from the plate to form an ink-receiving area.

The prepared lithographic plate may be dyed with a solution of a dye to detect and proofread the image. The dye is contained in the etching solution, or the plate is treated with a solution of a dye after the etching treat' ment. The plate may be softly rubbed with a soft pad containing the solution of a dye to dye the image area. Thus the development is confirmed even within the high light area. The dye preferably is dissolved or dispersed in water. Acidic or basic dyes are available. Two or more dyes may be used in combination. The solution may be prepared by dissolving or dispersing the dye in a solvent such as water, an alcohol, a ketone, an ether. Two or more solvents may be used in combination. A carbon compound, an amine, a surface active agent or an auxochlomic agent may be added to the solution to improve the function of the dye.

The dyed plate is preferably washed with water, and dried to improve the handling of the plate, since stickiness is removed from the surface of the plate with water.

In the case that the treated plates are stacked, a paper is preferably placed between the plates to protect them.

The above-mentioned etching and dying treatments and washing and drying processes are preferably conducted in an automatic processing machine. The processing machine is disclosed in JP-A-2-220061.

### EXAMPLE 1

### Formation of Drimer layer

An aluminum sheet according to JIS-A-1050 (thickness: 0.3 mm) was defatted by a conventional method. The sheet was immersed in 1 % aqueous solution of an aminosilane coupling agent (KBM603 produced by Shinetsu Chemical Industry Co., Ltd.), and dried at room temperature. The following coating solution of the primer layer was coated on the aluminum sheet, and dried at 140 °C for 2 minutes to form a primer layer having dry thickness of 4 g/m².

| Coating solution of primer layer | |
|---|---|
| Polyurethane (Sanprene IB1700D produced by Sanyo Chemical Industries, Ltd.) | 10 g |
| Isocyanate (Takenate D110N produced by Takeda Chemical Industries, Ltd.) | 0.5 g |
| TiO₂ | 0.1 g |
| Nonionic surfactant containing fluorine atoms (MCF323 produced by Dainippon Ink & Chemicals Inc.) | 0.03 g |
| Propylene glycol methylether acetate | 50 g |
| Methyl lactate | 20 g |

### Formation of polymerizable layer

The following coating solution was coated over the primer layer on the aluminum sheet, and the coated layer of the solution was dried at 100 °C for 1 minute to form a polymerizable layer having dry thickness of 2 g/m².

| Coating solution of polymerizable layer | |
|---|---|
| Dipentaerythritol hexaacrylate | 1.0 g |
| 20 wt.% Propylene glycol monomethyl ether solution of allyl methacrylate/methacrylic acid copolymer (copolymerization ratio = 83/17) | 37.5 g |
| Polyethylene oxide diacrylate (A-1000 produced by Shin-nakamura Chemicals Co., Ltd.) | 0.5 g |
| Nonionic surfactant containing fluorine atoms (MCF323 produced by Dainippon Ink & Chemicals Inc.) | 0.03 g |
| Methyl ethyl ketone | 10.0 g |
| Propylene glycol monomethylether | 20.0 g |

### Formation of ink-repellent layer

The following coating solution was coated over the polymerizable layer, and the coated layer of the solution was dried at 120 °C for 2 minutes to form an ink-repellent layer having dry thickness of 2 g/m².

| Coating solution of ink-repellent layer | |
|---|---|
| α,ω-Divinylpolydimethlsiloxane (polymerization degree: about 700) | 1.0 g |
| (CH₃)₃-Si-O-(Si(CH₃)₂-O-)₃₀-(SiH(CH₃)-O-)₁₀-Si(CH₃)₃ | 1.2 g |
| Olefin complex of chloroplatinic acid | 0.2 g |
| Cross-linking inhibitor | 0.3 g |
| Hydrocarbon solvent (Isoper G produced by Esso Chemical Co., Ltd.) | 140.0 g |

### Protective film

A biaxially stretched polypropylene film (thickness: 3 mm) was laminated on the ink-repellent layer.

### Preparation of silver halide emulsion

Gelatin, potassium bromide and water were placed in a vessel. Ammonia was added to the vessel at 55 °C. While the reaction solution was kept at pAg of 7.60, an aqueous solution of silver nitrate and an aqueous solution of potassium bromide were added to the vessel according to a double jet method. Potassium iodide was then added to the vessel to prepare a monodispersed silver iodobromide emulsion (average particle size: 0.25 µm, silver iodide content: 2 mole %). In the emulsion, 98 % of the silver halide grains have a grain size within ± 40 of the average grain size.

The emulsion was desalted, and adjusted to pH of 6.2 and pAg of 8.6. The emulsion was then subjected to a gold-sulfur sensitization using sodium thiosulfate and chloroauric acid. Further, to the resulting emulsion was added a methanol solution (2 mole/l) of the following sensitizing dye (amount: 200 cm³ (cc) per 1 kg of the emulsion). Then the emulsion was stirred at 60 °C for 15 minutes.

### (Sensitizing dye)

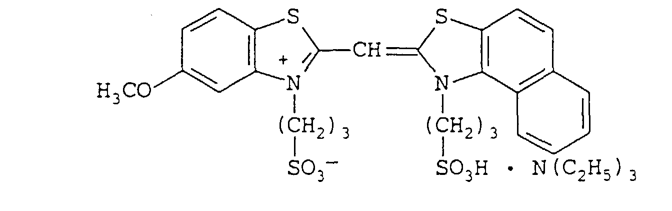

### Preparation of reducing agent dispersion

In 90 g of 3 wt.% aqueous solution of polyvinyl alcohol (PVA-205 produced by Kuraray Co., Ltd.) were dispersed 10 g of powder of the following reducing agent using Dynomill dispersing device.

### (Reducing agent)

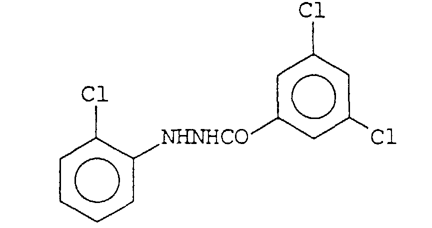

### Preparation of light-sensitive layer

The following coating solution was coated over the protective film, and the coated layer of the solution was dried to give a light-sensitive layer having dry thickness of 1.2 µm.

| Coating solution of light-sensitive layer | |
|---|---|
| 6 wt. % aqueous solution of polyvinyl alcohol (PVA-420 produced by Kuraray Co., Ltd., saponification degree: 79.5 %) | 10.5 g |
| 0.11 wt. % methanol solution of the following additive | 0.83 g |
| The above-prepared reducing agent dispersion | 1.0 g |
| The above-prepared silver halide emulsion | 0.5 g |
| 5 weight % aqueous solution of the following surface active agent | 0.4 g |
| Water | 7.8 g |

### (Additive)

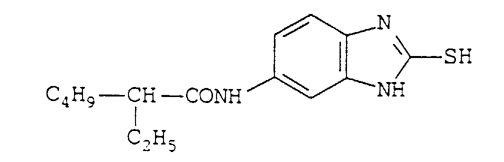

### (Surface active agent)

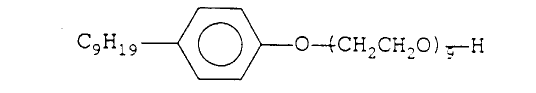

### Preparation of base precursor dispersion

In 750 g of a 3 wt.% aqueous solution of polyvinyl alcohol (PVA-205. produced by Kuraray Co., Ltd.) were dispersed 250 g of the following base precursor using Dynomill dispersing device. The particle size of the base precursor was about not more than 0.5 µm.

### (Base precursor)

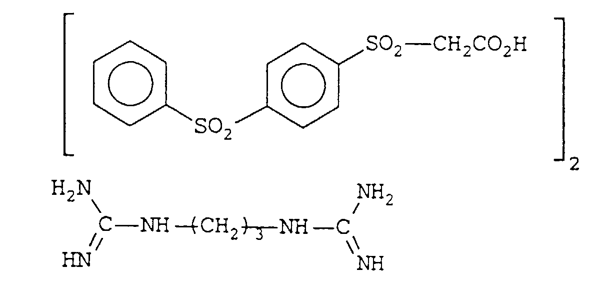

### Preparation of overcoating layer

The following coating solution was coated over the above-prepared light-sensitive layer, and the coated layer of the solution was dried to give an overcoating layer having a dry thickness of about 3.3 pm. Thus a presensitized lithographic plate of the present invention was prepared.

| Coating solution of overcoating layer | |
|---|---|
| 10 weight % aqueous solution of polyvinyl alcohol (PVA-110, tradename of Kuraray Co., Ltd., saponification degree: 98.5 %) | 20.0 g |
| The above-prepared base precursor dispersion | 1.25 g |
| 5 weight % aqueous solution of the surface active agent used in the preparation of the light-sensitive layer | 4.0 g |

### Preparation of lithographic plate and printing

The presensitized lithographic plate was brought into close contact with an original film, and was exposed to light of a tungsten lamp of 100 W for 1 second through a band pass filter of 500 nm. Then, the back surface of the lithographic plate (i.e., side of the aluminum support) was brought into close contact with a hot plate heated to 140°C for 30 seconds under the condition that the overcoating layer side surface was opened to air, to develop the material thermally. Thus, a silver image was found on the exposed area. Then, the protective film, the light-sensitive layer and the overcoating layer was removed from the plate. Thereafter, the lithographic plate was immersed in water at 35 °C, and rubbed with a pad to remove the silicone rubber layer within the unexposed (image) area. The plate was immersed in the following solution of a dye for 10 seconds. Thus unexposed area was dyed, and an image was detected.

| Solution of dye | |
|---|---|
| Crystal violet | 0.1 g |
| Ethyl diglycol | 15.0 g |
| Water | 85.0 g |

The obtained lithographic plate was washed with water and dried. The plate was attached to a printing machine (Komori Lithron 26) to which a dampening arrangement had been detached, and printed using a black ink (Aqualess-G produced by Toyo Ink Mfg. Co., Ltd.). As a result, an excellent print was obtained.

### EXAMPLE 2

A lithographic plate was prepared in the same manner as in Example 1, except that the following coating solution of the polymerizable layer was used, and the dry thickness of polymerizable layer was changed from 2 to 5 g/m². As a result, excellent image and print were obtained.

| Coating solution of polymerizable layer | |
|---|---|
| Polyurethane (Sanprene IB1700D produced by Sanyo Chemical Industries, Ltd.) | 5.0 g |
| Addition product of 1 mole of xylenediamine with 4 mole of glycidyl methacrylate | 1.0 g |
| Nonionic surfactant containing fluorine atoms (MCF323 produced by Dainippon Ink & Chemicals Inc.) | 0.03 g |
| Methyl ethyl ketone | 10.0 g |
| Propylene glycol monomethylether | 25.0 g |

### EXAMPLE 3

A presensitized lithographic plate was prepared in the same manner as in Example 1, except that the light-sensitive layer and the overcoating layer were directly coated on the polymerizable layer without use of the protective film. In preparation of the plate, the light-sensitive layer and the overcoating layer were removed by washing with water, and then the silicone rubber layer within the unexposed area was removed from the plate. As a result, excellent image and print were obtained.similarly to the results of Example 1.

### EXAMPLE 4

After the primer layer was formed in the same manner as in Example 1, the following coating solution was coated on the primer layer and dried to form a light-sensitive layer having dry thickness of 1.5 µm.

| Coating solution of light-sensitive layer | |
|---|---|
| 6 wt. % aqueous solution of polyvinyl alcohol (PVA-110 produced by Kuraray Co., Ltd., saponification degree: 79.5 %) | 10.5 g |
| 0.11 wt.% methanol solution of the additive used in Example 1 | 0.83 g |
| The reducing agent dispersion used in Example 1 | 1.0 g |
| The base precursor dispersion used in Example 1 | 1.5 g |
| The silver halide emulsion used in Example 1 | 0.5 g |
| 5 weight % aqueous solution of the surface active agent used in Example 1 | 0.4 g |
| Water | 7.8 g |

The polymerizable layer and the ink-repellent layer were formed on the light-sensitive layer in the order. A biaxially stretched polyethylene terephthalate film (thickness: 10 mm) was laminated on the ink-repellent layer to prepare a presensitized lithographic plate of the present invention.

## Claims

1. A presensitized lithographic plate which contains silver halide, a reducing agent and an ethylenically unsaturated polymerizable compound or a cross-linkable polymer provided on a support, wherein the presensitized lithographic plate comprises the support, a polymerizable layer uniformly containing the polymerizable compound or the cross-linkable polymer, an ink-repellent layer and a light-sensitive layer containing silver halide in that order, wherein the ink-repellent layer contains a cross-linked silicone rubber or a cross-linked fluororesin.

2. The presensitized lithographic plate as claimed in claim 1, wherein the presensitized lithographic plate further contains a base or base precursor.

3. A process for preparation of a lithographic plate comprising the steps of:
- imagewise exposing to light the presensitized lithographic plate defined in any one of claims 1 or 2;
- simultaneously or thereafter heating the plate at a temperature of not lower than 60°C to develop the silver halide and to harden the polymerizable compound or the cross-linked polymer; and
- removing the ink-repellent layer on the unhardened area of the polymerizable layer.

4. The process for preparation of the lithographic plate as claimed in claim 3, wherein the plate is heated at a temperature in the range of 80 to 200°C.

5. The process for preparation of the lithographic plate as claimed in claim 3, wherein the plate is heated for 0.5 to 180 seconds.

6. The process for preparation of the lithographic plate as claimed in claim 3, wherein the ink-repellent layer on the unhardened area of the polymerizable layer is removed by washing the plate with an aqueous solution of an organic solvent.

7. The process for preparation of the lithographic plate as claimed in claim 5, wherein the unhardened area of the plate is dyed after the ink-repellent layer on the unhardened area of the polymerizable layer is removed.

8. A presensitized lithographic plate which contains silver halide, a reducing agent and an ethylenically unsaturated polymerizable compound or a cross-linkable polymer provided on a support, wherein the presensitized lithographic plate comprises the support, a light-sensitive layer containing silver halide, a polymerizable layer uniformly containing the polymerizable compound or the cross-linkable polymer and an ink-repellent layer in that order, wherein the ink-repellent layer contains a cross-linked silicone rubber or a cross-linked fluororesin.

9. The presensitized lithographic plate as claimed in claim 8, wherein the presensitized lithographic plate further contains a base or base precursor.

10. A process for preparation of a lithographic plate comprising the steps of:
- imagewise exposing to light a presensitized lithographic plate defined in any one of claims 8 or 9;
- simultaneously or thereafter heating the plate at a temperature of not lower than 60°C to develop the silver halide and to harden the polymerizable compound or the cross-linkable polymer; and
- removing the ink-repellent layer on the unhardened area of the polymerizable layer.

11. The process for preparation of the lithographic plate as claimed in claim 10, wherein the plate is heated at a temperature in the range of 80 to 200°C.

12. The process for preparation of the lithographic plate as claimed in claim 10, wherein the plate is heated for 0.5 to 180 seconds.

13. The process for preparation of the lithographic plate as claimed in claim 10, wherein the ink-repellent layer on the unhardened area of the polymerizable layer is removed by washing the plate with an aqueous solution of an organic solvent.

14. The process for preparation of the lithographic plate as claimed in claim 10, wherein the unhardened area of the plate is dyed after the ink-repellent layer on the unhardened area of the polymerizable layer is removed.

## Patentansprüche

1. Vorsensibilisierte lithographische Platte, enthaltend auf einem Träger bereitgestelltes Silberhalogenid, ein Reduktionsmittel und eine ethylenisch ungesättigte polymerisierbare Verbindung oder ein vernetzbares Polymer, worin die vorsensibilisierte lithographische Platte den Träger, eine gleichförmig die polymerisierbare Verbindung oder das vernetzbare Polymer enthaltende polymerisierbare Schicht, eine Tinte-abstoßende Schicht und eine Silberhalogenid enthaltende lichtempfindliche Schicht in dieser Reihenfolge umfaßt, worin die Tinte-abstoßende Schicht einen vernetzten Silikonkautschuk oder ein vernetztes Fluorharz enthält.

2. Vorsensibilisierte lithographische Platte nach Anspruch 1, worin die vorsensibilisierte lithographische Platte weiterhin eine Base oder einen Basenvorläufer enthält.

3. Verfahren zur Herstellung einer lithographischen Platte, umfassend die Schritte:
- bildweises Belichten der in einem der Ansprüche 1 oder 2 definierten vorsensibilisierten lithographischen Platte;
- gleichzeitiges oder anschließendes Erhitzen der Platte bei einer Temperatur von nicht niedriger als 60°C zum Entwickeln des Silberhalogenids und zum Härten der polymerisierbaren Verbindung oder des vernetzten Polymers; und
- Entfernen der Tinte-abstoßenden Schicht auf der ungehärteten Fläche der polymerisierbaren Schicht.

4. Verfahren zur Herstellung der lithographischen Platte nach Anspruch 3, worin die Platte bei einer Temperatur im Bereich von 80 bis 200°C erhitzt wird.

5. Verfahren zur Herstellung der lithographischen Platte nach Anspruch 3, worin die Platte für 0,5 bis 180 Sekunden erhitzt wird.

6. Verfahren zur Herstellung der lithographischen Platte nach Anspruch 3, worin die Tinte-abstoßende Schicht auf der nicht gehärteten Fläche der polymerisierbaren Schicht durch Waschen der Platte mit einer wäßrigen Lösung eines organischen Lösungsmittels entfernt wird.

7. Verfahren zur Herstellung der lithographischen Platte nach Anspruch 5, worin die nicht gehärtete Fläche der Platte gefärbt wird, nachdem die Tinte-abstoßende Schicht auf der nicht gehärteten Fläche der polymerisierbaren Schicht entfernt ist.

8. Vorsensibilisierte lithographische Platte enthaltend auf einem Träger bereitgestelltes Silberhalogenid, ein Reduktionsmittel und eine ethylenisch ungesättigte polymerisierbare Verbindung oder ein vernetzbares Polymer, worin die vorsensibilisierte lithographische Platte den Träger, eine Silberhalogenid enthaltende lichtempfindliche Schicht, eine gleichförmig die polymerisierbare Verbindung oder das vernetzbare Polymer enthaltende polymerisierbare Schicht und eine Tinte-abstoßende Schicht in dieser Reihenfolge umfaßt, worin die Tinte-abstoßende Schicht einen vernetzten Silikonkautschuk oder ein vernetztes Fluorharz enthält.

9. Vorsensibilisierte lithographische Platte nach Anspruch 8, worin die vorsensibilisierte lithographische Platte weiterhin eine Base oder einen Basenvorläufer enthält.

10. Verfahren zur Herstellung einer lithographischen Platte umfassend die Schritte:
- bildweises Belichten einer in einem der Ansprüche 8 oder 9 definierten vorsensibilisierten lithographischen Platte;
- simultanes oder anschließendes Erhitzen der Platte bei einer Temperatur von nicht niedriger als 60°C zum Entwickeln des Silberhalogenids und zum Härten der polymerisierbaren Verbindung oder des vernetzbaren Polymers; und
- Entfernen der Tinte-abstoßenden Schicht auf der ungehärteten Fläche der polymerisierbaren Schicht.

11. Verfahren zur Herstellung der lithographischen Platte nach Anspruch 10, worin die Platte bei einer Temperatur im Bereich von 80 bis 200°C erhitzt wird.

12. Verfahren zur Herstellung der lithographischen Platte nach Anspruch 10, worin die Platte für 0,5 bis 180 Sekunden erhitzt wird.

13. Verfahren zur Herstellung der lithographischen Platte nach Anspruch 10, worin die Tinte-abstoßende Schicht auf der nicht gehärteten Fläche der polymerisierbaren Schicht durch Waschen der Platte mit einer wäßrigen Lösung eines organischen Lösungsmittels entfernt wird.

14. Verfahren zur Herstellung der lithographischen Platte nach Anspruch 10, worin die nicht gehärtete Fläche der Platte gefärbt wird, nachdem die Tinte-abstoßende Schicht auf der nicht gehärteten Fläche der polymerisierbaren Schicht entfernt ist.

## Revendications

1. Plaque lithographique présensibilisée qui contient de l'halogénure d'argent, un agent réducteur et un composé polymérisable éthyléniquement insaturé ou un polymère réticulable fournis sur un support, dans laquelle la plaque lithographique présensibilisée comprend le support, une couche polymérisable contenant uniformément le composé polymérisable ou le polymère réticulable, une couche repoussant l'encre et une couche photosensible contenant de l'halogénure d'argent dans cet ordre, dans laquelle la couche repoussant l'encre contient un caoutchouc de silicone réticulé ou une résine fluorée réticulée.

2. Plaque lithographique présensibilisée selon la revendication 1, dans laquelle la plaque lithographique présensibilisée contient en outre une base ou un précurseur de base.

3. Procédé pour la préparation d'une plaque lithographique comprenant les étapes consistant :
- à exposer à la manière d'une image la plaque lithographique présensibilisée définie dans l'une quelconque des revendications 1 ou 2 à la lumière;
- à chauffer simultanément ou après cela la plaque à une température qui n'est pas inférieure à 60°C pour développer l'halogénure d'argent et pour durcir le composé polymérisable ou le polymère réticulé; et
- à éliminer la couche repoussant l'encre sur la surface non durcie de la couche polymérisable.

4. Procédé pour la préparation de la plaque lithographique selon la revendication 3, dans lequel la plaque est chauffée à une température dans l'intervalle de 80 à 200°C.

5. Procédé pour la préparation de la plaque lithographique selon la revendication 3, dans lequel la plaque est chauffée pendant de 0,5 à 180 secondes.

6. Procédé pour la préparation de la plaque lithographique selon la revendication 3, dans lequel la couche repoussant l'encre sur la surface non durcie de la couche polymérisable est éliminée par lavage de la plaque avec une solution aqueuse d'un solvant organique.

7. Procédé pour la préparation de la plaque lithographique selon la revendication 5, dans lequel la surface non durcie de la plaque est séchée après que la couche repoussant l'encre sur la surface non durcie de la couche polymérisable est éliminée.

8. Plaque lithographique présensibilisée qui contient de l'halogénure d'argent, un agent réducteur et un composé polymérisable éthyléniquement insaturé ou un polymère réticulable fournis sur un support, dans laquelle la plaque lithographique présensibilisée comprend le support, une couche photosensible contenant de l'halogénure d'argent, une couche polymérisable contenant uniformément le composé polymérisable ou le polymère réticulable et une couche repoussant l'encre dans cet ordre, dans laquelle la couche repoussant l'encre contient un caoutchouc de silicone réticulé ou une résine fluorée réticulée.

9. Plaque lithographique présensibilisée selon la revendication 8, dans laquelle la plaque lithographique présensibilisée contient en outre une base ou un précurseur de base.

10. Procédé pour la préparation d'une plaque lithographique comprenant des étapes consistant :
- à exposer à la manière d'une image une plaque lithographique présensibilisée définie dans l'une quelconques des revendications 8 ou 9 à la lumière;
- à chauffer simultanément ou après cela la plaque à une température qui n'est pas inférieure à 60°C pour développer l'halogénure d'argent et pour durcir le composé polymérisable ou le polymère réticulable; et
- à éliminer la couche repoussant l'encre sur la surface non durcie de la couche polymérisable.

11. Procédé pour la préparation de la plaque lithographique selon la revendication 10, dans lequel la plaque est chauffée à une température dans l'intervalle de 80 à 200°C.

12. Procédé pour la préparation de la plaque lithographique selon la revendication 10, dans lequel la plaque est chauffée pendant de 0,5 à 180 secondes.

13. Procédé pour la préparation de la plaque lithographique selon la revendication 10, dans lequel la couche repoussant l'encre sur la surface non durcie de la couche polymérisable est éliminée par lavage de la plaque avec une solution aqueuse d'un solvant organique.

14. Procédé pour la préparation de la plaque lithographique selon la revendication 10, dans lequel la surface non durcie de la plaque est séchée après que la couche repoussant l'encre sur la surface non durcie de la couche polymérisable est éliminée.
